Europäisches Patentamt

European Patent Office

Office européen des brevets

(11) Publication number: **0 186 740**
**B1**

# EUROPEAN PATENT SPECIFICATION

(45) Date of publication of the patent specification:
05.09.90

(51) Int. Cl.⁵: **G01R 19/175**

(21) Application number: **85112813.2**

(22) Date of filing: **30.12.82**

(60) Publication number of the earlier application in accordance
with Art. 76 EPC: **0112948**

(54) Power frequency detection system.

(43) Date of publication of application:
**09.07.86 Bulletin 86/28**

(45) Publication of the grant of the patent:
**05.09.90 Bulletin 90/36**

(84) Designated Contracting States:
**DE FR GB IT**

(56) References cited:
**EP-A- 0 112 948**
**DE-B- 2 713 945**

**IBM TECHNICAL DISCLOSURE BULLETIN, vol. 24,
no. 10, March 1982, pages 5025-5027, New York, US; J.H.
DODGE et al.: "Microcomputer control of zero-corssing
detection accuracy"
PATENTS ABSTRACTS OF JAPAN, vol. 6,
no. 141 (P-131)[1019], 30th July 1982; & JP - A
- 57 64 170 (TEAC K.K.) 19-04-1982**

(73) Proprietor: **SHARP KABUSHIKI KAISHA,
22-22 Nagaike-cho Abeno-ku, Osaka 545(JP)**

(72) Inventor: **Ise, Masahiro, 2187 Mise-cho, Kashihara-shi
Nara-ken(JP)**
Inventor: **Tanaka, Hidehiko, 2613-1 Ichinomoto-cho,
Tenri-shi Nara-ken(JP)**
Inventor: **Machino, Katsuyuki, 1400-150 Fusa Abiko-Shi,
Chiba-Ken(JP)**
Inventor: **Matsubara, Toshiyuki, 2613-1 Ichinomoto-cho,
Tenri-shi Nara-ken(JP)**
Inventor: **Terasaka, Teiji, 2613-1 Ichinomoto-cho,
Tenri-shi Nara-ken(JP)**

(74) Representative: **Wright, Peter David John et al, R.G.C.
Jenkins & Co. 26 Caxton Street, London SW1H 0RJ(GB)**

Note: Within nine months from the publication of the mention of the grant of the European patent, any person may give notice to
the European Patent Office of opposition to the European patent granted. Notice of opposition shall be filed in a written reasoned
statement. It shall not be deemed to have been filed until the opposition fee has been paid (Art. 99(1) European patent
convention).

## Description

The present invention relates to a detection system for detecting a frequency of a power supply voltage and, preferably, to a power frequency detection circuit in a signal transmission system which utilizes the building or house wiring.

A signal transmission system has been developed, which utilizes the building or house wiring as a data transmission line. In such a signal transmission system, the power frequency is often used as a reference clock. To achieve accurate operation, the power frequency must be correctly detected without interference from noise.

The present invention therefore relates to a system of the type which is operable to provide detection signals when the level of the power voltage reaches a predetermined value, and comprises a microcomputer which is operable to inhibit the provision of said detection signals for a predetermined period after the provision of each detection signal.

IBM Technical Disclosure Bulletin Vol. 24 No. 10, March 1982 discloses at pages 5025 to 5027 an arrangement in which a microprocessor performs a predetermined count based on the microcomputer internal clock following each accepted zero-crossing. No further zero-crossings are accepted until the count is finished, so as to create an "inspection window" in the vicinity of the anticipated next zero-crossing time. Thus noise signals occurring during the count are ignored. The count takes a predetermined period slightly less than the period of the timing signal to be obtained from the power voltage.

The present invention provides an alternative arrangement for ignoring noise for predetermined periods.

According to the present invention there is provided a power line signal transmission system which includes a detection system for detecting the frequency of a power supply voltage on the power line, the detection system being operable to provide detection signals when the level of the power voltage reaches a predetermined value, characterised in that said detection system comprises a micro-computer which is operable to inhibit the provision of detection signals for a predetermined period after the provision of each detection signal, the micro-computer having an input/output terminal coupled to a timing circuit, the micro-computer being responsive to a said detection signal to provide an output signal at said terminal in order to initiate operation of said timing circuit and being operable to sense a change in the level at said terminal caused by the timing circuit in order to detect the end of said predetermined period and thereupon permit provision of the following detection signal.

Usually the said predetermined value is substantially the centre value of the oscillations of the power voltage. Preferably the said predetermined period is less than half the period of the power voltage and the system is operable to provide detection signals when the power voltage passes the predetermined value in either direction.

In a preferred embodiment the timing circuit comprises an integrating means which determines the logic value at the input/output terminal by integrating the said output signal for initiating operation of the timing circuit, whereby the said logic value only becomes the logic value of the output signal after the said predetermined period has elapsed. Preferably the said integrating means comprises a capacitor.

An embodiment of the present invention, given by way of example, will now be described with reference to the accompanying drawings, in which:

FIGURE 1 is a schematic circuit diagram of a prior art power frequency detection circuit;

FIGURE 2 is a waveform chart for explaining an operational mode of the power frequency detection circuit of FIGURE 1;

FIGURE 3 is a circuit diagram of a power frequency detection system which is an embodiment of the invention of Application EP-A-0 112 948, published 11.7.1984, from which this application has been divided;

FIGURE 4 is a circuit diagram of another power frequency detection system which is an embodiment of the invention of Application EP-A-0 112 984 from which this application has been divided;

FIGURE 5 is a waveform chart for explaining operational modes of the power frequency detection systems of FIGURES 3 and 4;

FIGURE 6 is a flow chart for explaining an operational mode of a power frequency detection system which is not an embodiment of the present invention;

FIGURE 7 is a circuit diagram of a power frequency detection system which is an embodiment of the present invention;

FIGURE 8 is a waveform chart for explaining an operational mode of the power frequency detection system of FIGURE 7; and

FIGURE 9 is a flow chart for explaining an operational mode of the power frequency detection system of FIGURE 7.

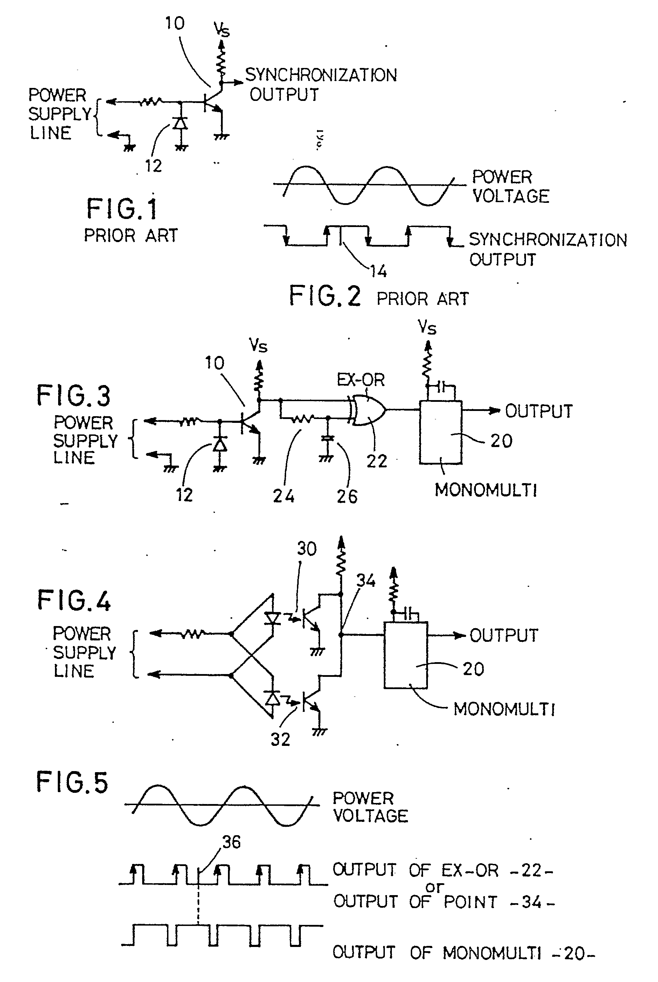

A signal transmission system has been developed which utilizes the building or house wiring as a data transmission line. In such a system, the power frequency is used as a base clock. To detect the power frequency, a zero-crossing level detection circuit is generally employed. FIGURE 1 shows a typical construction of the zero-crossing level detection circuit which includes a transistor 10 and a diode 12. A system timing signal is obtained through the use of the leading edge or the trailing edge of a synchronization output derived from the zero-crossing level detection circuit (see FIGURE 2).

In such a detection system, when noise is superimposed on the power supply voltage, there is a possibility that an erroneous detection output 14 appears in the synchronization output. Appearance of the erroneous detection output 14 depends on the noise level and the timing of the noise. The erroneous detection output 14 may lead to incorrect operation of the signal transmission system.

The frequency of occurrence of the erroneous detection output 14 is considerably lower than that of the power frequency. Furthermore, the power frequency is normally known. Therefore, if a system is constructed to ignore the power voltage variation for a preselected period of time after the last edge has been detected, the erroneous detection output 14 will be removed.

FIGURE 3 shows a first embodiment of the invention of Application EP-A-0 112 984 from which the present application has been divided. FIGURE 4 shows a second embodiment of the invention of application EP-A-0 112 984. The two embodiments differ from each other at an edge detection section for detecting the zero-crossing moment of the power supply voltage. Both embodiments include a monomultivibrator 20 (not retriggerable).

The monomultivibrator 20 must be triggered by edges of a same polarity every half cycle of the power supply voltage. In the arrangement of FIGURE 3, a detection output of a zero-crossing level detection circuit, which includes the transistor 10 and the diode 12, is applied directly to one input terminal of an exclusive OR gate 22. The other input terminal of the exclusive OR gate 22 receives a delayed detection output from the zero-crossing detection circuit via an integration circuit including a resistor 24 and a capacitor 26. The output signal of the exclusive OR gate 22 is applied to the monomultivibrator 20.

In the arrangement of FIGURE 4, a zero-crossing level detection circuit includes photo-couplers 30 and 32 which function, in combination, as a wired OR gate.

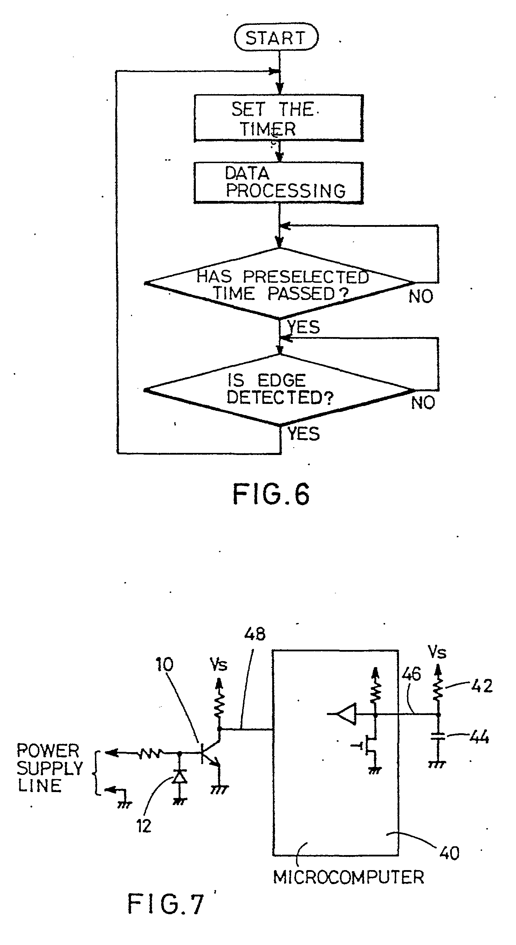

A point 34 provides a detection output signal as shown in FIGURE 5. The detection output signal thus obtained is applied to the monomultivibrator 20.

It will be clear from FIGURE 5 that the output signal of the exclusive OR gate 22 in FIGURE 3 and the output signal obtained at the point 34 in FIGURE 4 both bear a high level when the power voltage polarity changes. That is, the output signals of the exclusive OR gate 22 and the photo-couplers 30 and 32 are zero-crossing detection signals. Once the monomultivibrator 20 is set, noise such as an erroneous detection signal 36 are neglected as long as the monomultivibrator 20 is in the set state. That is, the output signal of the monomultivibrator 20 is not influenced by the erroneous detection signal 36. To ensure an accurate operation of the power frequency detection systems of FIGURES 3 and 4, the pulse width of the monomultivibrator 20 is selected to be slightly shorter than one half of the period of the power supply voltage. In a preferred form, the pulse width of the monomultivibrator 20 is selected at 7.5 milliseconds when the power supply voltage has a frequency of 60 Hz.

A microcomputer is widely used in the control system of a power line signal transmission system. Generally, the microcomputer includes a programmable timer.

FIGURE 6 shows a flow diagram which is not an embodiment of the present invention for operation when the above-mentioned programmable timer is used to control the power frequency detection. First, the programmable timer is set to a desired value. Then, the data processing is conducted. After the preselected period of time has passed, the above-mentioned edge detection is carried out.

When the edge is detected, the programmable timer is again set to perform the next edge detection.

Even when a programmable timer is not included in the microcomputer, a similar control can be conducted. A one-chip microcomputer 40 generally includes an input/output port of the bidirectional type. One of the bits can be used to form an analog integration timer as shown in FIGURE 7 which illustrates an embodiment of the present invention. More specifically, a resistor 42 and a capacitor 44 are connected to a terminal 46 of the microcomputer 40. The zero-crossing level detection circuit including the transistor 10 and the diode 12 is connected to a terminal 48 of the microcomputer 40.

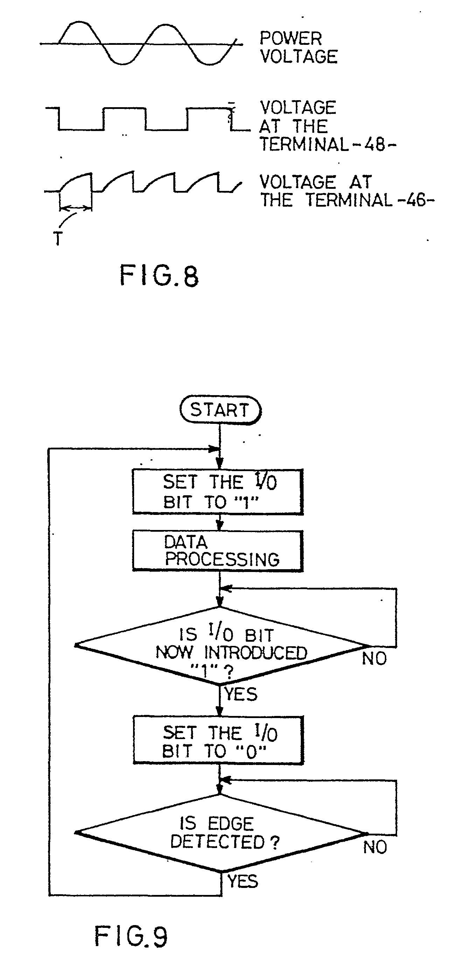

FIGURE 8 shows signals occurring within the circuit of FIGURE 7. FIGURE 9 shows a flow diagram of the operation of the circuit of FIGURE 7.

First, the input/output bit is set to output "1". Then, the data processing operation is conducted. Thereafter, a determination is conducted as to whether the input at input/output bit (input signal at the terminal 46) is "1". If an affirmative answer is obtained, the input/output bit is set to output "0", and the edge detection operation is carried out.

In this embodiment, the timer set period T (i.e. the period before the threshold voltage $V_{th}$ for input level "1" is reached) is represented as follows.

$$T = k\,C\,R$$

where:

$$k = -\ln\left(1 - \frac{V_{th}}{V_s}\right)$$

C is the capacitance value of the capacitor 44, and R is the resistance value of the resistor 42.

In a TTL type construction, $V_{th}$ is about 1.4 volts, and $V_s$ is 5 volts. Thus, k is 0.33. If the power supply voltage has the frequency of 60 Hz, then one half period is 8.3 milliseconds. Accordingly, if the timer set period T is desired to be set at a value slightly shorter than the one half period (8.3 milliseconds), for example, 7.5 milliseconds, the capacitance value C of the capacitor 44 should be selected between 6.9 microfarads and 6.8 microfarads because the resistor 42 is generally selected at 3.3 kilohms due to the sink current in the input/output port (generally, 1.6 milliamperes).

Attention is drawn to application EP-A-0 112 948 from which the present application has been divided.

**Claims**

1. A power line signal transmission system which includes a detection system for detecting the frequency of a power supply voltage on the power line, the detection system being operable to provide detection signals when the level of the power voltage reaches a predetermined value, characterised in that said detection system comprises a micro-computer (40) which is operable to inhibit the provision of detection signals for a predetermined period after the provision of each detection signal, the micro- computer (40) having an input/output terminal (46) coupled to a timing circuit (42, 44), the micro-computer (40) being responsive to a said detection signal to provide an output signal at said terminal (46) in order to initiate operation of said timing circuit (42, 44) and being operable to sense a change in the level at said terminal (46) caused by the timing circuit in order to detect the end of said predetermined period and thereupon permit provision of the following detection signal.

2. A system according to claim 1 in which the said predetermined value is substantially the centre value of the oscillations of the power voltage.

3. A system according to claim 1 or claim 2 in which the said predetermined period is less than half the period of the power voltage.

4. A system according to any one of the preceding claims in which the timing circuit comprises an integration timer which determines the logic value at the input/output terminal (46) by integrating the said output signal, whereby the said logic value only becomes the logic value of the output signal after the said predetermined period has elapsed, whereupon said micro-computer responds by permitting provision of said next detection signal.

5. A system according to claim 4 in which the said integration timer comprises a capacitor (44).

## Patentansprüche

1. Einrichtung zur Signalübertragung über eine Stromversorgungsleitung mit einer Prüfeinrichtung zur Ermittlung der Frequenz der auf der Leitung vorhandenen Versorgungsspannung, wobei die Prüfeinrichtung Prüfsignale liefert, wenn der Pegel der Versorgungsspannung einen bestimmten Wert erreicht, dadurch gekennzeichnet, daß die Prüfeinrichtung einen Mikrocomputer (40) aufweist, der die Abgabe von Prüfsignalen für eine festgelegte Periode nach dem Auftreten jedes Prüfsignals unterbindet, welcher Mikrocomputer (40) einen mit einer Zeitschaltung (42, 44) verbundenen Eingangs-/Ausgangs-Anschluß (46) aufweist und auf das Prüfsignal durch Abgabe eines Ausgangssignals an dem Anschluß (46) anspricht, um die Zeitschaltung (42, 44) zu aktivieren, sowie zur Feststellung von durch die Zeitschaltung verursachten Pegeländerungen an dem Anschluß (46), um das Ende der festgelegten Periode festzustellen, und um anschließend die Bereitstellung des folgenden Prüfsignals freizugeben.

2. Einrichtung nach Anspruch 1, bei dem der festgelegte Wert im wesentlichen dem Mittenwert der Schwingungen der Versorgungsspannung entspricht.

3. Einrichtung nach Anspruch 1 oder Anspruch 2, bei welcher die festgelegte Periode kleiner ist als die halbe Periode der Versorgungsspannung.

4. Einrichtung nach einem der vorstehenden Ansprüche, bei welcher die Zeitschaltung einen integrierenden Zeitgeber aufweist, welcher den logischen Wert am Eingangs-/Ausgangs-Anschluß (46) durch Integration des Ausgangssignals bestimmt und bei dem der logische Wert erst nach Ablauf der festgelegten Periode zum logischen Wert des Ausgangssignals wird, woraufhin der Mikrocomputer als Antwort die Freigabe des nächsten Prüfsignals zuläßt.

5. Einrichtung nach Anspruch 4, bei welcher der integrierende Zeitgeber einen Kondensator (44) aufweist.

## Revendications

1. Système de transmission de signaux par ligne secteur comportant un système de détection destiné à détecter la fréquence d'une tension d'alimentation sur la ligne secteur, ledit système de détection étant apte à fournir des signaux de détection lorsque le niveau de la tension d'alimentation atteint une valeur prédéterminée, caractérisé en ce que ledit système de détection comprend un micro-ordinateur (40) qui est apte à inhiber la fourniture de signaux de détection pendant une période prédéterminée suivant la fourniture de chaque signal de détection, le micro-ordinateur (40) ayant une borne d'entrée/sortie (46) couplée à un circuit de temporisation (42, 44), le micro-ordinateur (40) réagissant à un tel signal de détection pour fournir un signal de sortie au niveau de ladite borne (46) afin d'initialiser le fonctionnement dudit circuit de temporisation (42, 44) et étant apte à détecter un changement de niveau à ladite borne (46) provoqué par le circuit de temporisation pour détecter la fin de ladite période prédéterminée et autoriser, suite à cette détection, la fourniture du signal de détection suivant.

2. Système selon la revendication 1 dans lequel ladite valeur prédéterminée est sensiblement la valeur centrale des oscillations de la tension d'alimentation.

3. Système selon la revendication 1 ou la revendication 2 dans lequel ladite période prédéterminée est inférieure à la moitié de la période de la tension d'alimentation.

4. Système selon l'une quelconque des revendications précédentes dans lequel le circuit de temporisation comporte un temporisateur intégrateur qui détermine la valeur logique au niveau de la borne d'entrée/sortie (46) en intégrant ledit signal de sortie, si bien que ladite valeur logique ne devient la valeur logique du signal de sortie qu'à l'expiration de ladite période prédéterminée, instant auquel ledit micro-ordinateur réagit en autorisant la fourniture dudit signal de détection suivant.

5. Système selon la revendication 4 dans lequel ledit temporisateur intégrateur comprend un condensateur (44).

FIG.1
PRIOR ART

FIG.2 PRIOR ART

FIG.3
POWER
SUPPLY
LINE

FIG.4
POWER
SUPPLY
LINE

FIG.5

EP 0 186 740 B1

START

SET THE
TIMER

DATA
PROCESSING

HAS PRESELECTED
TIME PASSED ?    NO

YES

IS EDGE
DETECTED?    NO

YES

FIG.6

48

10    Vs    46    Vs    42

44

POWER
SUPPLY
LINE

12    40

MICROCOMPUTER

FIG.7

POWER
VOLTAGE

VOLTAGE
AT THE
TERMINAL -48-

VOLTAGE AT
THE TERMINAL -46-

T

FIG.8

START

SET THE I/O
BIT TO "1"

DATA
PROCESSING

IS I/O BIT
NOW INTRODUCED
"1" ?

NO

YES

SET THE I/O
BIT TO "0"

IS EDGE
DETECTED ?

NO

YES

FIG.9